# EUROPEAN PATENT APPLICATION

(11) **EP 4 845 359 A1**
(43) Date of publication of application: **25.11.2026**
(21) Application number: 26179728.6
(22) Date of filing: 19.05.2026
(51) Int. Cl.: H10H 29/34, H10H 29/49, H10H 29/853, H10H 20/819, H10H 20/831, H10H 29/80

(54) **LIGHT EMITTING MODULE**

(30) Priority: 20.05.2025 US 202563808758 P
(71) Applicant: Seoul Viosys Co., Ltd., Ansan-si, Gyeonggi-do 15429 (KR)
(72) Inventor: Kim, Changyoun, 15429 Ansan-si, Gyeonggi-do (KR)
(74) Representative: Stolmár & Partner Patentanwälte PartG mbB

(57) **Abstract**

The present invention discloses a light emitting module including a substrate including a wiring portion therein; a bonding layer disposed on a surface of the substrate; and first to third light emitting regions disposed on the bonding layer, to which power is applied through the wiring portion to emit light of different peak wavelengths.

## Description

### [Technical Field]

The present invention relates to a light emitting module including light emitting regions.

### [Background Art]

A light emitting diode (LED) is a light emitting device that emits light when current is applied. Recently, light emitting diodes (LEDs) have been widely used in various technical fields such as display apparatuses, vehicle lamps, and general lighting. Moreover, LEDs have advantages of long life, low power consumption, and fast response speed. By leveraging these advantages, LEDs have been rapidly replacing conventional light sources. For example, a display apparatus using LEDs can be manufactured by forming red (R), green (G), and blue (B) LED structures, which are individually grown on a final substrate.

A display apparatus generally implements various colors using a mixture of blue, green, and red. The display apparatus includes a plurality of pixels to implement various images, and each of the pixels includes blue, green, and red subpixels. The color of a particular pixel is determined by colors of these subpixels, and an image is implemented by the combination of these pixels.

### [Disclosure]

### [Technical Problem]

The present invention may provide a highly integrated light emitting module.

The present invention may provide a light emitting module with improved performance and reliability and high light extraction efficiency.

The present invention may provide a light emitting module capable of exhibiting reduced optical interference between pixels or between subpixels, preventing light bleed, and improving the directionality of emitted light.

The present invention may provide a light emitting module capable of improving productivity by simplifying a process.

The present invention may provide a light emitting module capable of increasing an amount of light by securing a large light-emitting area.

The present invention may provide a light emitting module capable of increasing light emitting efficiency by reducing loss of power applied thereto.

### [Technical Solution]

A light emitting module according to an embodiment of the present invention includes a substrate including a wiring portion therein; a bonding layer disposed on a surface of the substrate; and first to third light emitting regions disposed on the bonding layer, to which power is applied through the wiring portion to emit light of different peak wavelengths.

In an embodiment, at least one of the first to third light emitting regions may include a plurality of vertically stacked light emitting stacks.

In an embodiment, the plurality of light emitting stacks may be each an active light emitting stack that contributes to light emission in a current path when power is applied.

In an embodiment, the bonding layer may have electrical conductivity.

In an embodiment, wherein the wiring portion may include first to third wiring lines connected to correspond to each of the first to third light emitting regions, respectively.

In an embodiment, one of the first to third wiring lines may be electrically connected to a corresponding light emitting region through the bonding layer.

In an embodiment, the light emitting module may further include a common electrode disposed over the first to third light emitting regions and commonly connected to the first to third light emitting regions.

In an embodiment, at least one of the first to third light emitting regions may include a first light emitting stack; a first connection layer disposed over the first light emitting stack; a second light emitting stack disposed over the first connection layer; a second connection layer disposed over the second light emitting stack; and a third light emitting stack disposed over the second connection layer.

In an embodiment, the first connection layer and the second connection layer may be metallic bonding layers.

In an embodiment, each of the first to third light emitting stacks may include a first conductivity-type semiconductor layer, a second conductivity-type semiconductor layer, and an active layer disposed between the first and second conductivity-type semiconductor layers.

In an embodiment, the light emitting module may further include a light control layer disposed over the first to third light emitting regions.

In an embodiment, the light control layer may include a nano-micro structure on a light exiting surface.

In an embodiment, the nano-micro structure may be cone-shaped.

In an embodiment, the light emitting module may further include a light control layer disposed over the first to third light emitting regions.

In an embodiment, the light control layer may include protruding regions that protrude to correspond to each of the first to third light emitting regions.

In an embodiment, vertices of the protruding regions may be positioned at different heights from one another.

In an embodiment, each optical axis of the protruding regions may coincide with a center of a corresponding one of the first to third light emitting regions.

In an embodiment, the first to third light emitting regions may be disposed within a rectangular region to form one pixel.

In an embodiment, one of the first to third light emitting regions may have a larger light-emitting area than the other light emitting regions.

In an embodiment, one of the first to third light emitting regions may be provided as a plurality.

### [Advantageous Effect]

The present invention may provide a highly integrated light emitting module.

The present invention may provide a light emitting module with improved performance and reliability and high light extraction efficiency.

The present invention may provide a light emitting module capable of exhibiting reduced optical interference between pixels or between subpixels, preventing light bleed, and improving the directionality of emitted light.

The present invention may provide a light emitting module capable of improving productivity by simplifying a process.

The present invention may provide a light emitting module capable of increasing an amount of light by securing a large light-emitting area.

The present invention may provide a light emitting module capable of increasing light emitting efficiency by reducing loss of power applied thereto.

### [Brief Description of the Drawings]

FIG. 1A is a cross-sectional view showing a light emitting module according to a first embodiment of the present invention.
FIG. 1B is a top view showing the light emitting module of FIG. 1A.
FIG. 2 is a cross-sectional view showing a light emitting module according to a second embodiment of the present invention.
FIG. 3 is a cross-sectional view showing a light emitting module according to a third embodiment of the present invention.
FIG. 4 is a cross-sectional view showing a light emitting module according to a fourth embodiment of the present invention.
FIG. 5A is a cross-sectional view showing a light emitting module according to a fifth embodiment of the present invention.
FIG. 5B is a top view showing the light emitting module of FIG. 5A.
FIG. 6 is a cross-sectional view showing a light emitting module according to a sixth embodiment of the present invention.
FIG. 7 is a top view showing one pixel in a light emitting module of the present invention.
FIG. 8 is a top view showing pixels of FIG. 7.
FIG. 9 is a modified example of the pixel in FIG. 7.
FIG. 10 is a top view showing the pixels of FIG. 9.

### [Detailed Description of the Illustrated Embodiments]

In the following description, for the purposes of explanation, numerous specific details are set forth in order to provide thorough understanding of various exemplary embodiments or implementations of the present disclosure. As used herein, "embodiments" and "implementations" are interchangeable terms for non-limiting examples of devices or methods employing one or more of the inventive concepts disclosed herein. It will be apparent, however, that various exemplary embodiments may be practiced without these specific details or with one or more equivalent arrangements. In other instances, well-known structures and devices are shown in block diagram form in order to avoid unnecessarily obscuring various exemplary embodiments. Further, various exemplary embodiments may be different, but do not have to be exclusive. For example, specific shapes, configurations, and characteristics of an exemplary embodiment may be used or implemented in another exemplary embodiment without departing from the inventive concepts.

Unless otherwise specified, the illustrated exemplary embodiments are to be understood as providing exemplary features of varying detail of some ways in which the inventive concepts may be implemented in practice. Therefore, unless otherwise specified, the features, components, modules, layers, films, panels, regions, and/or aspects (hereinafter individually or collectively referred to as "elements") of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, and property of the elements, unless specified. Further, in the accompanying drawings, the size and relative sizes of elements may be exaggerated for clarity and/or descriptive purposes. When an exemplary embodiment is implemented differently, a specific process order may be performed differently from the described order. For example, two consecutively described processes may be performed substantially at the same time or performed in an order opposite the described order. In addition, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the DR1-axis, the DR2-axis, and the DR3-axis are not limited to three axes of a rectangular coordinate system, such as the x, y, and z-axes, and may be interpreted in a broader sense. For example, the DR1-axis, the DR2-axis, and the DR3-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," and the like may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (for example, as in "sidewall"), and the like, may be used herein for descriptive purposes, and, thereby, to describe one element's relationship to other element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (for example, rotated 90 degrees or at other orientations), and, as such, the spatially relative descriptors used herein may likewise interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various exemplary embodiments are described herein with reference to sectional and/or exploded illustrations that are schematic illustrations of idealized exemplary embodiments and/or intermediate structures. As such, variations from the shapes of the illustrations as a result, for example, of manufacturing techniques and/or tolerances, are to be expected. Thus, exemplary embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some exemplary embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (for example, microcode) to perform various functions discussed herein and may optionally be driven by firmware and/or software. It is also contemplated that each block, unit, and/or module may be implemented by dedicated hardware, or as a combination of dedicated hardware to perform some functions and a processor (for example, one or more programmed microprocessors and associated circuitry) to perform other functions. Also, each block, unit, and/or module of some exemplary embodiments may be physically separated into two or more interacting and discrete blocks, units, and/or modules without departing from the scope of the inventive concepts. Further, the blocks, units, and/or modules of some exemplary embodiments may be physically combined into more complex blocks, units, and/or modules without departing from the scope of the inventive concepts.

Unless otherwise defined, all terms (including technical and scientific terms) used herein have the same meaning as commonly understood by one of ordinary skill in the art to which this disclosure pertains. Terms, such as those defined in commonly used dictionaries, should be interpreted as having a meaning that is consistent with their meaning in the context of the relevant art and should not be interpreted in an idealized or overly formal sense, unless expressly so defined herein.

Hereinafter, a light emitting module according to the present invention will be described in detail through the accompanying drawings.

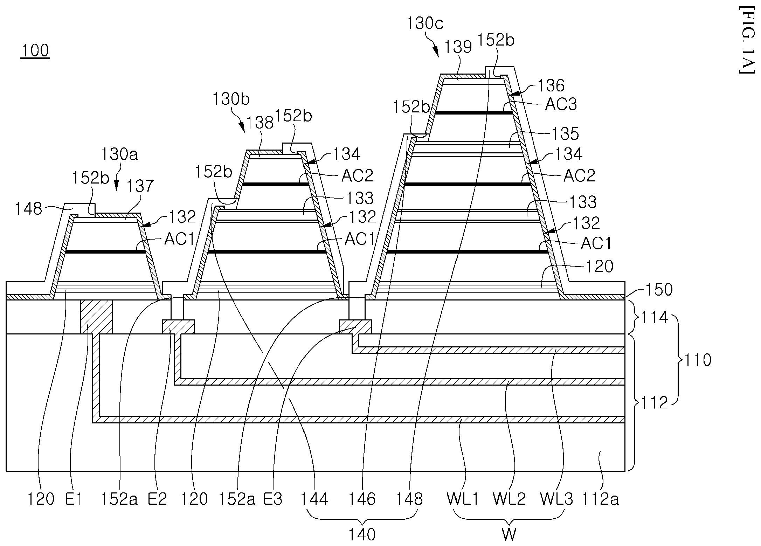

First, referring to FIG. 1A, a light emitting module 100 according to a first embodiment of the present invention may include a substrate 110 having a wiring portion W therein, a bonding layer 120 disposed on a surface of the substrate 110, and a plurality of light emitting regions 130a, 130b, and 130c disposed on the bonding layer 120 and to which power is applied through the wiring portion W.

The substrate 110 is provided with the wiring portion W therein and supports the plurality of light emitting regions 130a, 130b, and 130c, and various configurations are possible. For example, the substrate 110 may be a circuit board, a light-transmitting substrate, a glass substrate, a TFT substrate, a polymer substrate, a flexible substrate, a polyimide substrate, or others, and is not limited to a specific type. In addition, the substrate 110 may be formed with an area larger than that of the plurality of light emitting regions 130a, 130b, and 130c. Through this, a stable light emitting module 100 may be fabricated.

The wiring portion W may include a plurality of wiring lines WL1, WL2, and WL3 connected to correspond to each of the plurality of light emitting regions 130.

The substrate 110 may include a base substrate layer 112 on which the wiring lines WL1, WL2, and WL3 are disposed, and an insulating substrate layer 114 disposed over the base substrate layer 112. Through this, current may be stably supplied to the plurality of light emitting regions 130a, 130b, and 130c.

The base substrate layer 112 may include a multilayer structure. The base substrate layer 112 may include a base substrate 112a thereunder and a wiring layer 112b including the wiring lines WL1, WL2, and WL3. The base substrate 112a may be formed of various materials such as Si, glass, ceramic, and polymer, or others, and may provide stable support and heat dissipation functions.

The wiring layer 112b is a layer in which the wiring lines WL1, WL2, and WL3 are formed between multiple insulation layers, and may transmit electrical signals through the wiring lines WL1, WL2, and WL3.

End portions E1, E2, and E3 of the wiring lines WL1, WL2, and WL3 may extend to the insulating substrate layer 114.

The insulating substrate layer 114 may be an upper passivation layer of the substrate 110, and may enable electrical insulation between the end portions E1, E2, and E3 of the wiring lines WL1, WL2, and WL3. The insulating substrate layer 114 may be formed of a metal oxide-based inorganic insulating material such as silicon oxide (SiO₂), aluminum oxide (Al₂O₃), hafnium oxide (HfO₂), tantalum oxide (Ta₂O₅), or zirconium oxide (ZrO₂), or an organic insulating material such as silicone-based polymer, polyimide (PI), epoxy resin, polyphenylene sulfide (PPS), polytetrafluoroethylene (PTFE), or the like.

The wiring lines WL1, WL2, and WL3 may be provided in a number corresponding to the plurality of light emitting regions 130a, 130b, and 130c. For example, as illustrated in FIG. 1A, when the light emitting module 100 includes the first through third light emitting regions 130a, 130b, and 130c, the wiring portion W may include a first wiring line WL1 connected to a first light emitting region 130a, a second wiring line WL2 connected to a second light emitting region 130b, and a third wiring line WL3 connected to a third light emitting region 130c.

The bonding layer 120 is a layer disposed on a surface of the substrate 110 and may be a metallic bonding layer for securing the light emitting regions 130a, 130b, and 130c. The bonding layer 120 may have characteristics of adhesiveness, electrical conductivity, and thermal conductivity. For example, the bonding layer 120 may be an AuSn alloy or solder.

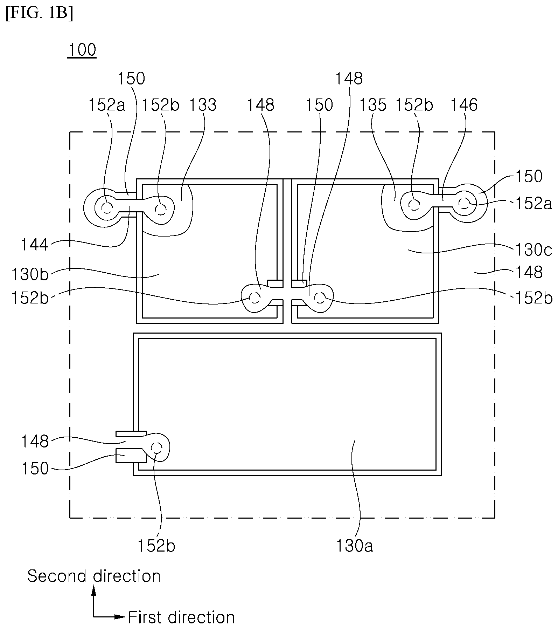

The light emitting regions 130a, 130b, and 130c are light emitting structures disposed on the bonding layer 120 and applied with power through the wiring portion W, and various configurations are possible. The light emitting module 100 includes the plurality of light emitting regions 130a, 130b, and 130c, and, for example, may include the first through third light emitting regions 130a, 130b, and 130c. FIG. 1 exemplarily illustrates that the light emitting module 100 includes three light emitting regions 130a, 130b, and 130c, but the light emitting regions 130a, 130b, and 130c may be provided in two or more numbers.

The plurality of light emitting regions 130a, 130b, and 130c may be spaced apart from one another on a surface of the substrate 110. In addition, the plurality of light emitting regions 130a, 130b, and 130c may be independently driven and controlled. Power applied to the plurality of light emitting regions 130a, 130b, and 130c may be controlled independently of one another. Referring to FIG. 1A, for example, the light emitting module 100 may include the first light emitting region 130a, the second light emitting region 130b, and the third light-emitting region 130c that are spaced apart and controlled independently of one another.

The light emitting regions 130a, 130b, and 130c may include light emitting stacks 132, 134, and 136. The light emitting stacks 132, 134, and 136 may include a first conductivity type semiconductor layer, a second conductivity type semiconductor layer, and an active layer AC1, AC2, or AC3 disposed between the first and second conductivity type semiconductor layers.

The first conductivity type semiconductor layer may be a semiconductor layer grown on a surface of a growth substrate, and may include a phosphide or nitride semiconductor such as (Al, Ga, In)P or (Al, Ga, In)N. In addition, the first conductivity type semiconductor layer may be doped as n-type by including one or more impurities such as Si, C, Ge, Sn, Te, Pb, or others. The present invention is not limited thereto, and as another example, the first conductivity type semiconductor layer may be doped with an opposite conductivity type by including a p-type dopant. Furthermore, the first conductivity type semiconductor layer may be formed as a single layer or multiple layers. The growth substrate may be removed later.

The second conductivity type semiconductor layer may include a phosphide or nitride semiconductor such as (Al, Ga, In)P or (Al, Ga, In)N. The second conductivity type semiconductor layer may be doped as a conductivity type opposite to that of the first conductivity type semiconductor layer. For example, the second conductivity type semiconductor layer may be doped as a p-type by including an impurity such as Mg.

The active layer AC1, AC2, or AC3 is a light emitting layer disposed between the first conductivity type semiconductor layer and the second conductivity type semiconductor layer, may include a phosphide or nitride semiconductor such as (Al, Ga, In)P or (Al, Ga, In)N, and may be grown on the first conductivity type semiconductor layer using a technique such as MOCVD, MBE, HVPE, or the like.

In addition, the active layer AC1, AC2, or AC3 may include a quantum well structure (QW) including at least two barrier layers and at least one well layer, and further may include a multi quantum well structure (MQW) including a plurality of barrier layers and a plurality of well layers. Wavelengths of light emitted from the active layers AC1, AC2, and AC3 may be adjusted by controlling a composition ratio of materials forming the well layer. In this case, the well layers may include a same element in common, for example, In.

A light exiting surface on which light is emitted may be formed on a side of the first conductivity type semiconductor layer or the second conductivity type semiconductor layer. For example, light generated in the active layers AC1, AC2, and AC3 may be emitted to the outside by passing through the first conductivity semiconductor layer or by passing through the second conductivity semiconductor layer. A concave-convex structure may be formed on a surface of the first conductivity type semiconductor layer or a surface of the second conductivity type semiconductor layer so as to increase light extraction efficiency.

At least one of the light emitting regions 130a, 130b, and 130c may include a plurality of active layers AC1, AC2, and AC3. That is, at least one of the light emitting regions 130a, 130b, and 130c may include a plurality of light emitting stacks 132, 134, and 136.

For example, as illustrated in FIG. 1, the first light emitting region 130a may include one first light emitting stack 132, the second light emitting region 130b may include two first and second light emitting stacks 132 and 134, and the third light emitting region 130c may include three first through third light emitting stacks 132, 134, and 136. A number of light emitting stacks 132, 134, and 136 included in each of the light emitting regions 130a, 130b, and 130c may be variously changed.

The first through third light emitting stacks 132, 134, and 136 may respectively include a first conductivity type semiconductor layer, a second conductivity type semiconductor layer, and the active layers AC1, AC2, and AC3 disposed between the first and second conductivity type semiconductor layers.

In this case, the first light emitting region 130a may include the first light emitting stack 132. The second light emitting region 130b may include the first light emitting stack 132, a first connection layer 133 disposed over the first light emitting stack 132, and the second light emitting stack 134 disposed over the first connection layer 133. The third light emitting region 130c may include the first light emitting stack 132, the first connection layer 133 disposed over the first light emitting stack 132, the second light emitting stack 134 disposed over the first connection layer 133, a second connection layer 135 disposed over the second light emitting stack 134, and the third light emitting stack 136 disposed over the second connection layer 135. The first light emitting region 130a may further include a transparent electrode layer 137 disposed over the first light emitting stack 132. The second light emitting region 130b may further include a transparent electrode layer 138 disposed over the second light emitting stack 134. The third light emitting region 130c may further include a transparent electrode layer 139 disposed over the third light emitting stack 136. The transparent electrode layers 137, 138, and 139 may be ITO layers.

The first connection layer 133 and the second connection layer 135 may be insulation layers having insulating characteristics and may be adhesive layers that secure the light emitting stacks 132, 134, and 136.

Meanwhile, the first through third light emitting stacks 132, 134, and 136 may emit light of peak wavelengths different from one another when power is applied. That is, each of the active layers AC1, AC2, and AC3 of the first through third light emitting stacks 132, 134, and 136 may emit light when power is applied, and the active layers AC1, AC2, and AC3 may emit light having peak wavelengths different from one another.

For example, the active layer AC1 of the first light emitting stack 132 may emit light in a red wavelength band, the active layer AC2 of the second light emitting stack 134 may emit light in a blue wavelength band, and the active layer AC3 of the third light emitting stack 136 may emit light in a green wavelength band. As another example, the active layer AC1 of the first light emitting stack 132 may emit light in the green wavelength band, the active layer AC2 of the second light emitting stack 134 may emit light in the blue wavelength band, and the active layer AC3 of the third light emitting stack 136 may emit light in the red wavelength band.

Meanwhile, the active layers AC1, AC2, and AC3 of the first through third light emitting stacks 132, 134, and 136 may include a same Group V material. Alternatively, the active layers AC1, AC2, and AC3 of the first through third light emitting stacks 132, 134, and 136 may include a same Group III material. In this case, contents of Group V material or Group III material in the active layers AC1, AC2, and AC3 of each of the first through third light emitting stacks 132, 134, and 136 may differ from one another.

Meanwhile, the light emitting module 100 may include a passivation layer 150 covering the light emitting regions 130a, 130b, and 130c, and an electrode portion 140 connected to the light emitting regions 130a, 130b, and 130c through an opening 152 of the passivation layer 150. Power may be applied to the light emitting regions 130a, 130b, and 130c through the electrode portion 140.

The passivation layer 150 is a layer for electrical insulation between each of the light emitting regions 130a, 130b, and 130c, and may be formed of various materials. The passivation layer 150 may be a layer formed of SiO₂.

The passivation layer 150 may cover a side surface of the bonding layer 120 and an exposed surface of the substrate 110 together with the light emitting regions 130a, 130b, and 130c.

The electrode portion 140 may include a common electrode 148 disposed over the light emitting regions 130a, 130b, and 130c and commonly connected to the plurality of light emitting regions 130a, 130b, and 130c.

The common electrode 148 may be commonly connected to first conductivity type semiconductor layers or second conductivity type semiconductor layer of each light emitting region 130a, 130b, or 130c. The common electrode 148 may extend along side surfaces of the light emitting regions 130a, 130b, and 130c to upper surfaces of the light emitting region 130a, 130b, and 130c.

In addition, the electrode portion 140 may further include individual electrodes 144 and 146 individually connected to the light emitting regions 130a, 130b, and 130c.

Meanwhile, power may be applied to the light emitting regions 130a, 130b, and 130c from the outside through the electrode portion 140 and the wiring lines WL1, WL2, and WL3. The wiring lines WL1, WL2, and WL3 may be connected to corresponding light emitting regions 130a, 130b, and 130c through the individual electrodes 144 and 146.

In this case, one of the wiring lines WL1, WL2, and WL3 may be electrically connected to the corresponding light emitting region 130a, 130b, or 130c through the bonding layer 120 having the electrical conductivity without the individual electrodes 144 and 146. The bonding layer 120 may be in contact with the end portion E1 of the first wiring line WL1 on a lower surface.

In detail, referring to FIGs. 1A and 1B, the first light emitting region 130a may be electrically connected to the first wiring line WL1 in a lower portion through the bonding layer 120. The second light emitting region 130b may be electrically connected to the second wiring line WL2 through a corresponding individual electrode 144. The third light emitting region 130c may be electrically connected to the third wiring line WL3 through a corresponding individual electrode 146.

The first light emitting region 130a includes one first light emitting stack 132, and when power is applied between the bonding layer 120 having the electrical conductivity and the common electrode 148, light may be emitted from the first light emitting stack 132.

The opening 152 of the passivation layer 150 may include a first opening 152a for exposing the end portions E2 and E3 of the wiring lines WL2 and WL3 and a second opening 152b for exposing portions of the light emitting regions 130a, 130b, and 130c. The first opening 152a may be an opening for connecting the wiring lines WL2 and WL3 and the individual electrodes 144 and 146, and the second opening 152b may be an opening for connecting the electrode portion 140 and the light emitting regions 130a, 130b, and 130c.

Meanwhile, the second light emitting region 130b and the third light emitting region 130c include the plurality of light emitting stacks 132, 134, and 136, and at least one of the plurality of light emitting stacks 132, 134, and 136 may be an inactive light emitting stack that is out of a current path between the individual electrode 144 or 146 and the common electrode 148.

In a case of the second light emitting region 130b, among the first and second light emitting stacks 132 and 134, the first light emitting stack 132 may be an inactive light emitting stack that is out of the current path between the individual electrode 144 and the common electrode 148.

In a case of the third light emitting region 130c, among the first through third light emitting stacks 132, 134, and 136, the first and second light emitting stacks 132 and 134 may be inactive light emitting stacks that are out of the current path between the individual electrode 146 and the common electrode 148.

In detail, in the first light emitting region 130a, the common electrode 148 may extend along a side surface of the first light emitting stack 132 to an upper surface thereof and may be connected to the first conductivity type semiconductor layer of the first light emitting stack 132 through the second opening 152b formed on the upper surface thereof. In this case, the end portion E1 of the first wiring line WL1 may be connected to the second conductivity type semiconductor layer of the first light emitting stack 132 through the bonding layer 120.

In the second light emitting region 130b, the common electrode 148 may extend along side surfaces of the first and second light emitting stacks 132 and 134 to an upper surface of the second light emitting stack 134 and may be connected to the first conductivity type semiconductor layer of the second light emitting stack 134 through the second opening 152b formed on the upper surface of the second light emitting stack 134. In this case, the individual electrode 144 may be connected to the end portion E2 of the second wiring line WL2 through the first opening 152a formed on a surface of the substrate 110, and may extend along the side surface of the first and second light emitting stacks 132 and 134 and may be connected to the second conductivity type semiconductor layer of the second light emitting stack 134 through the second opening 152b.

In the third light emitting region 130c, the common electrode 148 may extend along side surfaces of the first through third light emitting stacks 132, 134, and 136 to an upper surface of the third light emitting stack 136 and may be connected to the first conductivity type semiconductor layer of the third light emitting stack 136 through the second opening 152b formed on the upper surface of the third light emitting stack 136. In this case, the individual electrode 146 may be connected to the end portion E3 of the third wiring line WL3 through the first opening 152a formed on a surface of the substrate 110, and may extend along the side surfaces of the first through third light emitting stacks 132, 134 and 136 and may be connected to the second conductivity type semiconductor layer of the third light emitting stack 136 through the second opening 152b.

FIG. 1B is a plan view illustrating the light emitting module 100 of FIG. 1A, which shows an arrangement of the first through third light emitting regions 130a, 130b, and 130c and the electrode portion 140.

FIG. 1A and FIG. 1B exemplarily illustrate that the light emitting module 100 includes one each of the first through third light emitting regions 130a, 130b, and 130c, but the present invention is not limited thereto. One of the first through third light emitting regions 130a, 130b, and 130c may be provided in a plurality.

In addition, one of the first through third light emitting regions 130a, 130b, and 130c may have a light-emitting area larger than those of the other light emitting regions 130a, 130b, and 130c. For example, as illustrated in FIG. 1B, the first light emitting region 130a may have a light-emitting area larger than those of the second and third light emitting regions 130b and 130c.

The first through third light emitting regions 130a, 130b, and 130c may form one pixel PX, and each of the light emitting regions 130a, 130b, and 130c may be a subpixel forming one pixel PX.

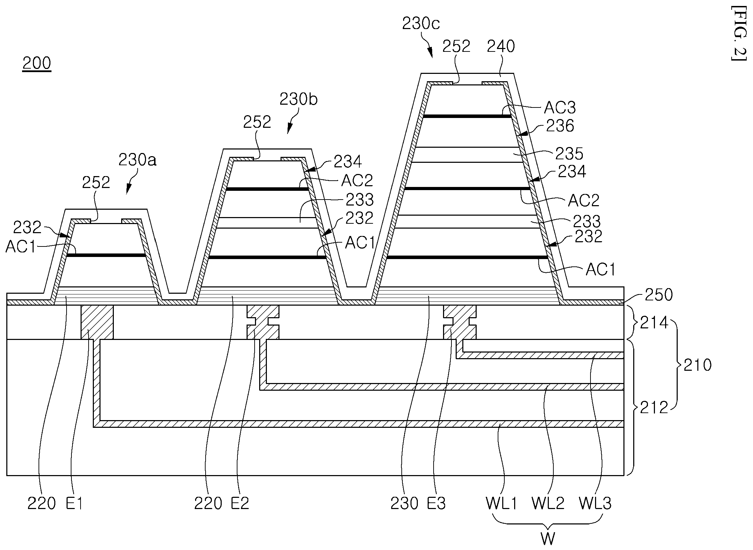

Next, FIG. 2 is a cross-sectional view showing a light emitting module 200 according to a second embodiment of the present invention. The light emitting module 200 according to the second embodiment will be described in detail, focusing on differences from the light emitting module 100 according to the first embodiment.

In the light emitting module 200, a first connection layer 233 and a second connection layer 235 may be configured to be identical or similar to those of the light emitting module 100 of the first embodiment, except that they are metallic bonding layers. As the first connection layer 233 and the second connection layer 235 are configured as the metallic bonding layers, second and third light emitting regions 230b and 230c do not include an inactive light emitting stack that is out of a current path.

That is, in the second light emitting region 230b, a current path may be formed along first and second light emitting stacks 232 and 234, and in the third light emitting region 230c, a current path may be formed along first through third light emitting stacks 232, 234, and 236.

When power is applied to a first light emitting region 230a, light of the first light emitting stack 232 may be emitted. When power is applied to the second light emitting region 230b, light may be emitted from the first light emitting stack 232 and the second light emitting stack 234. When power is applied to the third light emitting region 230c, light may be emitted from the first light emitting stack 232, the second light emitting stack 234, and the third light emitting stack 236.

Since the light emitting module 200 does not include an inactive light emitting stack, configurations corresponding to the individual electrodes 144 and 146 of the light emitting module 100 of the first embodiment may be omitted. In the light emitting module 200, an electrode portion 240 may be a common electrode covering the light emitting regions 230a, 230b, and 230c.

The electrode portion 240 may be connected to each of the light emitting regions 230a, 230b, and 230c through a second opening 252 of a passivation layer 250. In detail, the electrode portion 240 may be connected to a first conductivity type semiconductor layer of the first light emitting stack 232 through the second opening 252 disposed on an upper surface of the first light emitting region 230a. In addition, the electrode portion 240 may be connected to a first conductivity type semiconductor layer of the second light emitting stack 234 through the second opening 252 disposed on an upper surface of the second light emitting region 230b. In addition, the electrode portion 240 may be connected to a first conductivity type semiconductor layer of the third light emitting stack 236 through the second opening 252 disposed on an upper surface of the third light emitting region 230c.

In addition, the first through third light emitting regions 230a, 230b, and 230c may be electrically connected to corresponding first through third wiring lines WL1, WL2, and WL3 through a bonding layer 220. The bonding layer 220 on a lower side of the first light emitting region 230a may be in contact with an end portion E1 of the first wiring line WL1 on a lower surface. The bonding layer 220 on a lower side of the second light emitting region 230b may be in contact with an end portion E2 of the second wiring line WL2 on a lower surface. The bonding layer 220 on a lower side of the third light emitting region 230c may be in contact with an end portion E3 of the third wiring line WL3 on a lower surface.

Accordingly, power may be applied to the first through third light emitting regions 230a, 230b, and 230c through the bonding layer 220 without additional individual electrodes 144 and 146 as in the first embodiment and/or a configuration corresponding to the first opening 152a of the passivation layer 150. In detail, when power is applied between the end portion E1 of the first wiring line WL1 and the electrode portion 240, a current path is formed in the first light emitting region 230a, and light may be emitted from the first light emitting stack 232. When power is applied between the end portion E2 of the second wiring line WL2 and the electrode portion 240, a current path is formed in the second light emitting region 230b, and light may be emitted from the first and second light emitting stacks 232 and 234. When power is applied between the end portion E3 of the third wiring line WL3 and the electrode portion 240, a current path is formed in the third light emitting region 230c, and light may be emitted from the first through third light emitting stacks 232, 234, and 236.

In this case, a dominant wavelength of light emitted from the first through third light emitting regions 230a, 230b, and 230c may be determined by an applied current, that is, a current value or a current density.

For example, as a current value or a current density applied to the third light emitting region 230c increases, emitted light may be varied into a red wavelength band → a green wavelength band → a white light → a blue wavelength band.

Accordingly, by controlling the current value and the current density applied to each of the first through third light emitting regions 230a, 230b, and 230c, a color temperature and a wavelength band of light emitted from each of the light emitting regions 230a, 230b, and 230c may be adjusted differently.

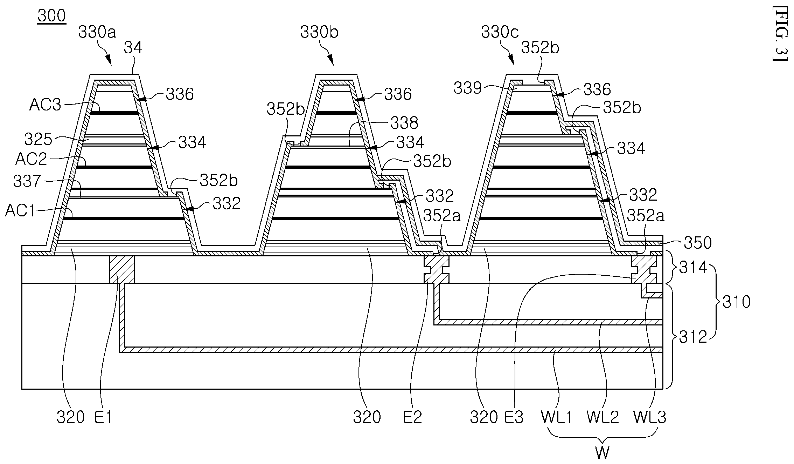

Next, FIG. 3 is a cross-sectional view showing a light emitting module 300 according to a third embodiment of the present invention. The light emitting module 300 according to the third embodiment will be described in detail, focusing on differences from the light emitting modules 100 and 200 according to the first and second embodiments.

In the light emitting module 300, each of first through third light emitting regions 330a, 330b, and 330c may include a plurality of light emitting stacks 332, 334, and 336. A number of light emitting stacks 332, 334, and 336 included in the first through third light emitting regions 330a, 330b, and 330c may be same.

For example, as illustrated in FIG. 3, each of the first through third light emitting regions 330a, 330b, and 330c may include first through third light emitting stacks 332, 334, and 336.

The first through third light emitting regions 330a, 330b, and 330b may include an inactive light emitting stack that is out of a current path when power is applied.

The first through third light emitting regions 330a, 330b, and 330c may include one light emitting stack 332, 334, or 336 that contributes to light emission. In this case, a first connection layer 333 and a second connection layer 335 may be insulation layers having insulating characteristics.

The first light emitting region 330a may include the first through third light emitting stacks 332, 334, and 336, among which the second and third light emitting stacks 334 and 336 may be inactive light emitting stacks that are out of a current path when power is applied. That is, only the first light emitting stack 332 may contribute to light emission in the first light emitting region 330a.

The second light emitting region 330b may include the first through third light emitting stacks 332, 334, and 336, among which the first and third light emitting stacks 334 and 336 may be inactive light emitting stacks that are out of a current path when power is applied. That is, only the second light emitting stack 334 may contribute to light emission in the second light emitting region 330b.

The third light emitting region 330c may include the first through third light emitting stacks 332, 334, and 336, among which the first and second light emitting stacks 332 and 334 may be inactive light emitting stacks that are out of a current path when power is applied. That is, only the third light emitting stack 336 may contribute to light emission in the third light emitting region 330c.

Accordingly, a second opening 352b of a passivation layer 350 in the first light emitting region 330a may be disposed in a first conductivity type semiconductor layer of the first light emitting stack 332. In the second light emitting region 330b, the second opening 352b of the passivation layer 350 may be disposed in a first conductivity type semiconductor layer of the second light emitting stack 334. In the third light emitting region 330c, the second opening 352b of the passivation layer 350 may be disposed in a first conductivity type semiconductor layer of the third light emitting stack 336.

In this case, one of the wiring lines WL1, WL2, and WL3 may be electrically connected to a corresponding light emitting region 330a, 330b, or 330c through a bonding layer 320 having an electrical conductivity without individual electrodes 344 and 346. The bonding layer 320 may be in contact with an end portion E1 of a first wiring line WL1 on a lower surface.

In detail, referring to FIG. 3, the first light emitting region 330a may be electrically connected to the first wiring line WL1 through the bonding layer 320 in a lower portion. The second light emitting region 330b may be electrically connected to a second wiring line WL2 through a corresponding individual electrode 344. The individual electrode 344 may be connected to an end portion E2 of the second wiring line WL2 through a first opening 352a of the passivation layer 350 and connected to a second conductivity type semiconductor layer of the second light emitting stack 334 through the second opening 352b. The third light emitting region 330c may be electrically connected to a third wiring line WL3 through a corresponding individual electrode 346. The individual electrode 346 may be connected to an end portion E3 of the third wiring line WL3 through the first opening 352a of the passivation layer 350 and connected to a second conductivity type semiconductor layer of the third light emitting stack 326 through the second opening 352b.

In the first light emitting region 330a, a common electrode 348 may be connected to the first conductivity type semiconductor layer of the first light emitting stack 332 through the second opening 352b of the passivation layer 350. In the second light emitting region 330b, the common electrode 348 may be connected to the first conductivity type semiconductor layer of the second light emitting stack 334 through the second opening 352b of the passivation layer 350. In the third light emitting region 330c, the common electrode 348 may be connected to the first conductivity type semiconductor layer of the third light emitting stack 336 through the second opening 352b of the passivation layer 350.

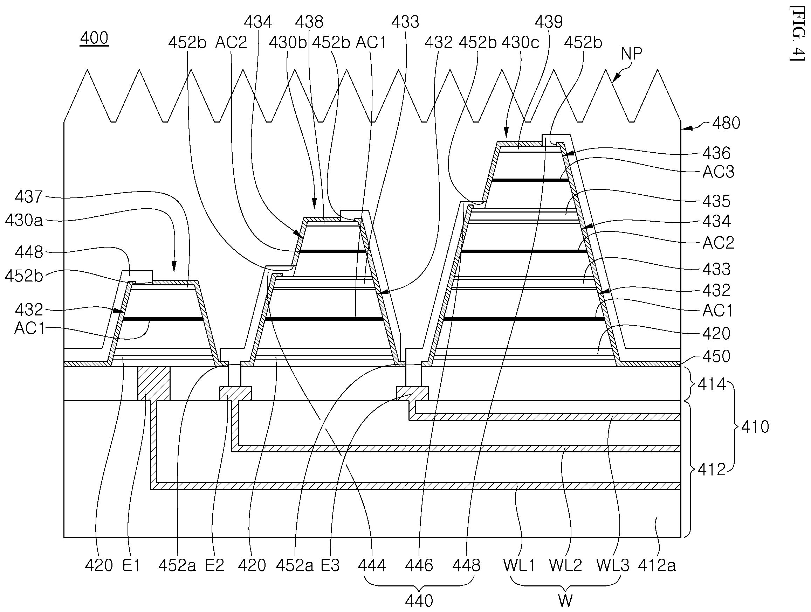

Next, FIG. 4 is a cross-sectional view showing a light emitting module 400 according to a fourth embodiment of the present invention. The light emitting module 400 according to the fourth embodiment will be described in detail, focusing on differences from the light emitting modules 100, 200, and 300 according to the first through third embodiments.

The light emitting module 400 may be configured to be identical or similar to the light emitting modules 100, 200, and 300 according to the first through third embodiments, except that it further includes a light control layer 480 disposed over a plurality of light emitting regions 430a, 430b, and 430c. It is apparent that the plurality of light emitting regions 430a, 430b, and 430c in the light emitting module 400 may be changed into a form identical or similar to that of the plurality of light emitting regions 230a, 230b, 230c, 330a, 330b, and 330c of FIG. 2 and FIG. 3.

The light control layer 480 is a layer covering the plurality of light emitting regions 430a, 430b, and 430c, and may control paths of light emitted from the plurality of light emitting regions 430a, 430b, and 430c.

An upper surface of the light control layer 480 may be a light exiting surface. The light control layer 480 may include a nano-micro structure NP on the light exiting surface. The nano-micro structure NP may include multiple micropatterns. For example, the nano-micro structure NP may include cone-shaped protrusions. Alternatively, the nano-micro structure NP may be a Moth eye structure. Light extraction efficiency may be improved through the nano-micro structure NP. Alternatively, anti-reflective function may be implemented through the nano-micro structure NP.

FIG. 4 illustrates the light control layer 480 as a single layer, but the present invention is not limited thereto. The light control layer 480 may include a lower light control layer covering the plurality of light emitting regions 430a, 430b, and 430c, and an upper light control layer disposed over the lower light control layer and having the nano-micro structure NP formed on the light exiting surface.

The light exiting surface of the light control layer 480 may have surface roughness due to the nano-micro structure NP.

For example, the nano-micro structure NP is a protrusion in a unit of several hundred nm to several µm, and may have a cone, pyramid, or hemispherical shape.

The light control layer 480 may be formed of various materials, such as polymers, inorganic materials, or the like.

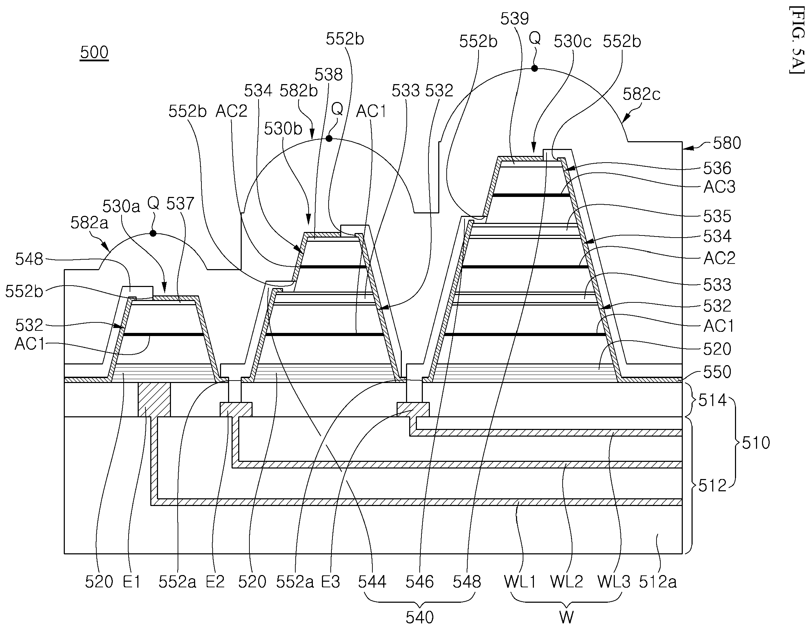

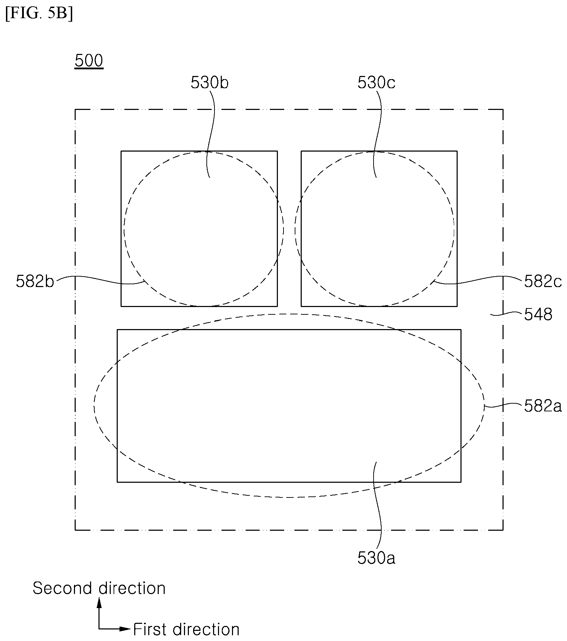

Next, FIG. 5A and FIG. 5B are cross-sectional views showing a light emitting module 500 according to a fifth embodiment of the present invention. The light emitting module 500 according to the fifth embodiment will be described in detail, focusing on differences from the light emitting module 400 according to the fourth embodiment. In a top view of FIG. 5B, electrode portions 540, 544, 546, and 548 are omitted from the illustration.

The light emitting module 500 may be configured to be identical or similar to the light emitting module 400 according to the fourth embodiment, except for a light control layer 580.

The light control layer 580 may include protruding regions 582a, 582b, and 582c that protrude in correspondence with a plurality of light emitting regions 530a, 530b, and 530c.

The protruding regions 582a, 582b, and 582c may have a convex lens shape. Convex surfaces of the protruding regions 582a, 582b, and 582c may be light exiting surfaces. Light may be focused on the convex surface, thereby improving the directionality of emitted light.

As the plurality of light emitting regions 530a, 530b, and 530c have different heights relative to a substrate 510, vertexes Q of each of the protruding regions 582a, 582b, and 582c may be positioned at different heights.

FIG. 5B is a plan view of the light emitting module 500 of FIG. 5A, and referring to FIG. 5B, a size of each of the protruding regions 582a, 582b, and 582c in plan view may correspond to a light-emitting area of the light emitting region 530a, 530b, or 530c disposed in a lower portion.

For example, a light-emitting area of a first light emitting region 530a may be larger than those of second and third light emitting regions 530b and 530c, and accordingly, the size of the protruding region 582a disposed over the first light emitting region 530a in plan view may be larger than those of the other protruding regions 582b and 582c in plan view. The present invention is not limited thereto, and the protruding region 582a over the first light emitting region 530a may have a same size as that of the protruding region 582b or 582c over the second or third light emitting region 530b or 530c in plan view. In this case, the protruding region 582a over the first light emitting region 530a may be formed in a plurality in proportion to an area ratio of the first light emitting region 530a. For example, when the light-emitting area of the first light emitting region 530a is twice as large as the light-emitting area of the second or third light emitting region 530b or 530c, two protruding regions 582a may be provided over the first light emitting region 530a.

FIG. 5B illustrates planar shapes of the protruding regions 582a, 582b, and 582c as circular or elliptical, but the present invention is not limited thereto. The planar shapes of the protruding regions 582a, 582b, and 582c can be various shapes such as circular, elliptical, or rectangular, and the inventive concepts are not limited to a specific shape.

In addition, in a case of FIG. 5B, although it is exemplarily illustrated that a portion of an edge of each light emitting region 530a, 530b, or 530c is positioned outside each corresponding protruding regions 582a, 582b, or 582c, alternatively, it is also possible to have an example in which each of the protruding regions 582a, 582b, and 582c covers an entire light-emitting area of each of the corresponding light emitting regions 530a, 530b, and 530c.

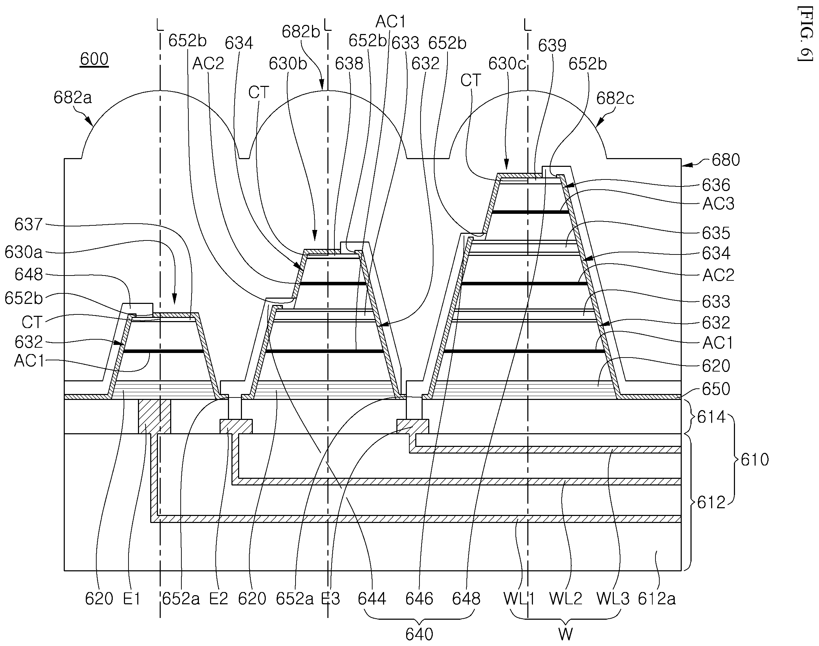

Next, FIG. 6 is a cross-sectional view showing a light emitting module 600 according to a sixth embodiment of the present invention. The light emitting module 600 according to the sixth embodiment will be described in detail, focusing on differences from the light emitting module 500 according to the fifth embodiment.

In the light emitting module 600 of the sixth embodiment, each optical axis L of protruding regions 682a, 682b, and 682c may coincide with a center CT of corresponding light emitting regions 630a, 630b, and 630c.

The optical axes L are virtual straight lines passing through centers of curved surfaces on convex surfaces of the protruding regions 682a, 682b, and 682c, and may pass through the centers of the protruding regions 682a, 682b, and 682c.

The center CT of the light emitting region 630a, 630b, or 630c may correspond to a centroid with respect to a light-emitting area of the light emitting region 630a, 630b, or 630c.

Even though the plurality of light emitting regions 630a, 630b, and 630c have different heights relative to a substrate 610, each vertex Q of the protruding regions 682a, 682b, and 682c may be positioned at a same height.

In this case, heights from the light emitting regions 630a, 630b, and 630c to each vertex Q of the protruding regions 682a, 682b, and 682c may differ from one another. In this case, the height from a first light emitting region 630a, which has a largest light-emitting area, to the vertex Q may be greatest. Through this, it is possible to secure a sufficient light path, thereby implementing a uniform light distribution.

In addition, sizes of the protruding regions 682a, 682b, and 682c in plan view may respectively correspond to the light-emitting areas of the light emitting region 630a, 630b, and 630c disposed thereunder.

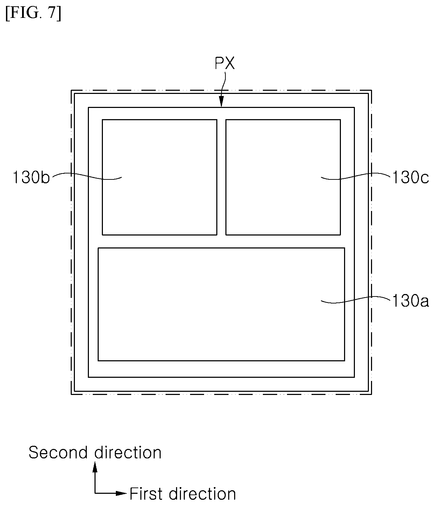

Next, FIG. 7 is a plan view showing one pixel PX formed in the light emitting module 100 of the present invention. FIG. 7 illustrates one pixel PX in the light emitting module 100 according to the first embodiment, but it is apparent that a pixel PX configuration of FIG. 7A may be applied in a same manner to the light emitting modules 200, 300, 400, 500, and 600 of the second through sixth embodiments.

The light emitting module 100 has the first through third light emitting regions 130a, 130b, and 130c emitting light of different peak wavelengths spaced apart in plan view, and the first through third light emitting regions 130a, 130b, and 130c may form one pixel PX. In this case, each of the first through third light emitting regions 130a, 130b, and 130c may correspond to a subpixel.

One pixel PX may form a rectangular region having a first direction and a second direction length perpendicular to the first direction. That is, the first through third light emitting regions 130a, 130b, and 130c may be disposed within the rectangular region to form one pixel PX.

One of the first through third light emitting regions 130a, 130b, and 130c, for example, the first light emitting region 130a may have a light-emitting area larger than those of the second and third light emitting regions 130b and 130c.

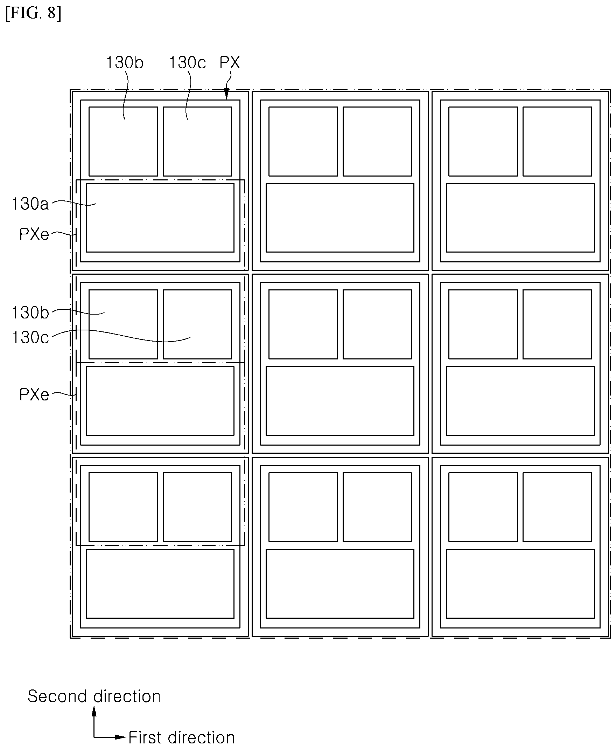

FIG. 8 illustrates pixels PX of FIG. 7 arranged in a matrix form in the first direction and the second direction, showing a possible arrangement of pixels PX in the light emitting module 100. FIG. 8 shows nine unit pixels PX disposed in a 3×3 matrix form in the first and second directions.

In a case of the light emitting module 100, nine unit pixels PX are arranged, but an effective pixel PXe in which the light emitting regions 130a, 130b, and 130c are overlapped between adjacent unit pixels PX may be added. That is, the light emitting module 100 still includes three unit pixels PX in the first direction, but two overlapping effective pixels PXe are added in the second direction, so that a total of five pixels PX may be formed. As a result, although nine unit pixels (PX) are disposed, the addition of the effective pixels (PXe) may produce an effect equivalent to having a total of fifteen pixels. This allows a smaller number of unit pixels to achieve the effect of a larger pixel arrangement, thereby increasing the integration density of the light emitting module 100.

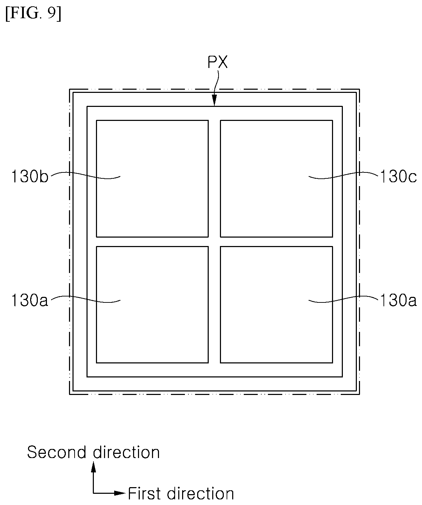

Next, FIG. 9 is a modified example of the unit pixel PX of FIG. 7. The first through third light emitting regions 130a, 130b, and 130c that emit light of different peak wavelengths and are spaced apart in plan view may form one unit pixel PX. In this case, one of the first through third light emitting regions 130a, 130b, and 130c may be provided in a plurality. For example, as shown in FIG. 9, two first light emitting regions 130a may be provided.

Within a unit pixel PX, two first light emitting regions 130a and the second and third light emitting regions 130b and 130c may be arranged in a 2×2 matrix form. The two first light emitting regions 130a may be arranged adjacently in a same row or column.

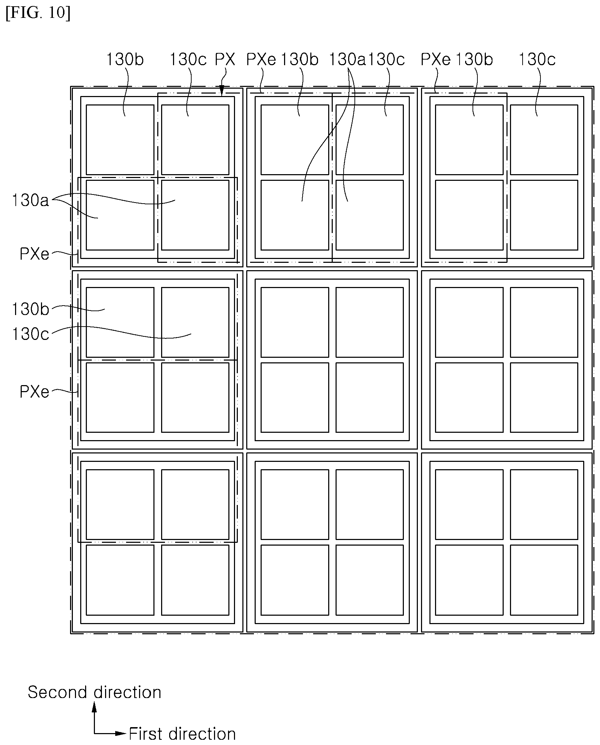

FIG. 10 illustrates pixels PX of FIG. 9 arranged in a matrix form in the first direction and the second direction, showing a possible arrangement of pixels PX in the light emitting module 100. FIG. 10 shows nine unit pixels PX disposed in a 3×3 matrix form in the first and second directions.

In a case of the light emitting module 100, nine unit pixels PX are arranged, but an effective pixel PXe in which the light emitting regions 130a, 130b, and 130c are overlapped between adjacent unit pixels PX may be added. That is, in the light emitting module 100, two effective pixels PXe overlapped in the first direction may be added, and two effective pixels PXe overlapped in the second direction may also be added, thereby, in total, forming five pixels PX in the first direction and five pixels PX in the second direction. As a result, although nine unit pixels (PX) are disposed, the addition of the effective pixels (PXe) can produce an effect equivalent to having a total of twenty-five pixels. This allows a smaller number of unit pixels to achieve the effect of a larger pixel arrangement, thereby increasing the integration density of the light emitting module 100.

Although the present disclosure has been described above with reference to preferred embodiments, it will be understood by those skilled in the art or having ordinary knowledge in the art that various modifications and changes may be made to the present disclosure without departing from the spirit and technical scope of the present disclosure as set forth in the claims below.

Therefore, the technical scope of the present disclosure should not be limited to the contents described in the detailed description of the specification, but should be defined by the scope of the patent claims.

### [Description of Reference Numerals]

100,200, 300, 400, 500, 600: Light emitting module
110, 210, 310, 410, 510, 610: Substrate
120, 220, 320, 420, 520, 620: Bonding layer
130a, 130b, 130c, 230a, 230b, 230c, 330a, 330b, 330c, 430a, 430b, 430c, 530a, 530b, 530c, 630a, 630b, 630c: Light emitting region

## Claims

1. A light emitting module, comprising: a substrate including a wiring portion therein; a bonding layer disposed on a surface of the substrate; and first to third light emitting regions disposed on the bonding layer, to which power is applied through the wiring portion to emit light of different peak wavelengths,
wherein at least one of the first to third light emitting regions includes a plurality of vertically stacked light emitting stacks, and
wherein the plurality of light emitting stacks are each an active light emitting stack that contributes to light emission in a current path when power is applied.

2. The light emitting module of claim 1, wherein the bonding layer has electrical conductivity.

3. The light emitting module of claim 2, wherein the wiring portion comprises first to third wiring lines connected to correspond to each of the first to third light emitting regions, respectively, and
wherein one of the first to third wiring lines is electrically connected to a corresponding light emitting region through the bonding layer.

4. The light emitting module of claim 1, further comprising a common electrode disposed over the first to third light emitting regions and commonly connected to the first to third light emitting regions.

5. The light emitting module of claim 1, wherein at least one of the first to third light emitting regions comprises: a first light emitting stack; a first connection layer disposed over the first light emitting stack; a second light emitting stack disposed over the first connection layer; a second connection layer disposed over the second light emitting stack; and a third light emitting stack disposed over the second connection layer.

6. The light emitting module of claim 5, wherein the first connection layer and the second connection layer are metallic bonding layers.

7. The light emitting module of claim 5, wherein each of the first to third light emitting stacks comprises a first conductivity-type semiconductor layer, a second conductivity-type semiconductor layer, and an active layer disposed between the first and second conductivity-type semiconductor layers.

8. The light emitting module of claim 1, further comprising a light control layer disposed over the first to third light emitting regions,
wherein the light control layer comprises a nano-micro structure on a light exiting surface.

9. The light emitting module of claim 8, wherein the nano-micro structure is cone-shaped.

10. The light emitting module of claim 1, further comprising a light control layer disposed over the first to third light emitting regions,
wherein the light control layer comprises protruding regions that protrude to correspond to each of the first to third light emitting regions.

11. The light emitting module of claim 10, wherein vertices of the protruding regions are positioned at different heights from one another.

12. The light emitting module of claim 10, wherein each optical axis of the protruding regions coincides with a center of a corresponding one of the first to third light emitting regions.

13. The light emitting module of claim 1, wherein the first to third light emitting regions are disposed within a rectangular region to form one pixel.

14. The light emitting module of claim 13, wherein one of the first to third light emitting regions has a larger light-emitting area than the other light emitting regions.

15. The light emitting module of claim 1, wherein one of the first to third light emitting regions is provided as a plurality.
